# EUROPÄISCHE PATENTANMELDUNG

(11) **EP 1 314 995 A2**
(43) Veröffentlichungstag der Anmeldung: **28.05.2003**
(21) Anmeldenummer: 02102608.3
(22) Anmeldetag: 20.11.2002
(51) Int. Cl.: G01R 33/341, G01R 33/36

(54) **HF-Spulenanordnung für Magnetresonanz-Bildgerät**

(30) Priorität: 21.11.2001 DE 10157039
(71) Anmelder: Philips Intellectual Property & Standards GmbH, 20099 Hamburg (DE); Koninklijke Philips Electronics N.V., 5621 BA Eindhoven (NL)
(72) Erfinder: Leussler, Christoph, 52088, Aachen (DE)
(74) Vertreter: Volmer, Georg, Dipl.-Ing.

(57) **Zusammenfassung**

Es wird eine HF-Spulenanordnung für ein Magnetresonanz-Bildgerät beschrieben, mit der eine weitgehend rechnergestützte und somit automatisch optimierte Bildqualität im Hinblick auf das Signal/Rausch-Verhältnis und das Auflösungsvermögen in Abhängigkeit von der Art und Größe des abzubildenden Objektes ohne zeitaufwendiges Auswechseln oder manuelles Positionieren der HF-Spulenanordnung erzielt werden kann. Die Spulenanordnung (A) umfasst hierzu eine Mehrzahl von einzelnen, im wesentlichen voneinander entkoppelten HF-Spulen (Sx) mit unterschiedlicher Größe und / oder unterschiedlicher Position, sowie eine Ansteuereinrichtung mit einer Mehrzahl von Sendeeinheiten, die jeweils einer HF-Spule zugeordnet sind, mit der eine oder mehrere HF-Spulen ausgewählt und mit einem HF-Puls mit unabhängig einstellbarer Amplitude und / oder Phase und / oder Pulsform beaufschlagt werden können. Die Erfindung betrifft auch ein Magnetresonanz-Bildgerät mit einer solchen HF-Spulenanordnung.

## Beschreibung

Die Erfindung betrifft eine HF-Spulenanordnung für ein Magnetresonanz-Bildgerät sowie ein solches Magnetresonanz-Bildgerät.

Magnetresonanz (MR)-Bildgeräte werden insbesondere zur Untersuchung und Behandlung von Patienten verwendet. Dabei werden die von einem Grundmagnetfeld ausgerichteten Kernspins des zu untersuchenden Gewebes durch HF-Impulse angeregt. Die dadurch ausgelösten HF-Relaxationsvorgänge werden Gradient-Magnetfeldern ausgesetzt, empfangen und verarbeitet, um ein Bild des Untersuchungsbereiches zu erzeugen.

Dabei ist zu unterscheiden zwischen den sogenannten offenen MR-Systemen (Vertikalsysteme), bei denen ein Patient in einen zwischen den Enden eines C-Arms liegenden Untersuchungsraum eingebracht wird und somit auch während der Untersuchung oder Behandlung von fast allen Seiten frei zugänglich ist, sowie den MR-Systemen mit einem rohrförmigen Untersuchungsraum (Axialsysteme), in den der Patient hineingeschoben wird. Diese Unterschiede bedingen auch ganz unterschiedliche Anordnungen und Gestaltungen der Einrichtungen, mit denen das Grundmagnetfeld, die Gradient-Magnetfelder sowie die HF-Signale erzeugt bzw. empfangen werden.

Zum Senden und Empfangen der HF-Signale sind HF-Spulenanordnungen erforderlich, deren Gestaltung und Position einen entscheidenden Einfluss auf die Bildqualität, das heißt insbesondere das Signal/Rausch-Verhältnis und das Auflösungsvermögen hat. Neben den fest im System eingebauten HF-Spulenanordnungen kommen dabei auch sogenannte HF-Körperspulen zum Einsatz, die flexibel, zum Beispiel als Manschetten oder Pads um bzw. auf den zu untersuchenden Bereich gelegt werden können.

Zur Optimierung bzw. Auswahl der HF-Spulenanordnungen sind nicht nur die Art des MR-Bildgerätes, sondern insbesondere auch verschiedene Patientendaten wie dessen Größe sowie die Art, Lage, Tiefe und Größe des zu untersuchenden Bereiches (Organs) und eventuelle Bewegungen in diesem Bereich usw. von entscheidender Bedeutung. Ein Anwender muss also zu Beginn einer Untersuchung im allgemeinen Versuchsaufnahmen mit HF-Spulen verschiedener Größe und in verschiedenen Positionen durchführen, um ein optimales Bild des zu untersuchenden Bereiches zu erzielen. Dies kann sehr zeitaufwendig sein, zumal dann, wenn der Patient dazu mehrfach aus dem MR-Gerät herausgefahren werden muss. Dies ist insbesondere bei einem Axialsystem der Fall.

Zur Vermeidung dieses Problems ist es zum Beispiel aus der DE 40 30 878 bekannt, eine Doppel-Oberflächenspule mit zwei Einzelspulen zu verwenden, die über Schalter wahlweise einzeln oder auch in Kombination aktiviert werden können, um eine optimale Bildqualität zu erzielen.

Eine Aufgabe, die der Erfindung zugrunde liegt, besteht darin, eine HF-Spulenanordnung der eingangs genannten Art zu schaffen, die auf relativ einfache Weise noch besser an eine bestimmte Aufnahmesituation angepasst werden kann, um dadurch die Bildqualität weiter zu erhöhen.

Weiterhin soll eine HF-Spulenanordnung der eingangs genannten Art geschaffen werden, mit der die Bildqualität gezielt im Hinblick auf bestimmte Parameter wie zum Beispiel das Signal/Rauschverhältnis oder das zeitliche oder räumliche Auflösungsvermögen optimiert werden kann.

Es soll auch eine HF-Spulenanordnung geschaffen werden, deren wirksame Größe und Position verändert werden kann, ohne dazu die Spulenanordnung auswechseln und einen Patienten aus dem MR-Gerät herausfahren zu müssen.

Schließlich soll auch ein MR-Bildgerät geschaffen werden, mit dem unter Anwendung der erfindungsgemäßen HF-Spulenanordnung eine relativ schnelle Bilderzeugung möglich ist, ohne dadurch eine Verschlechterung der Bildqualität in Kauf nehmen zu müssen.

Gelöst wird die Aufgabe gemäß Anspruch 1 mit einer HF-Spulenanordnung mit einer Mehrzahl von einzelnen, im wesentlichen voneinander entkoppelten HF-Spulen mit unterschiedlicher Größe und / oder unterschiedlicher Position, sowie mit einer Mehrzahl von Sendeeinheiten, die jeweils einer HF-Spule zugeordnet sind, zur Auswahl einer oder mehrerer HF-Spulen und zur Beaufschlagung der ausgewählten HF-Spulen mit einem HF-Sendepuls mit unabhängig einstellbarer Amplitude und / oder Phase und / oder Pulsform.

Diese Lösung vereint verschiedene Vorteile und eröffnet die Möglichkeit einer weitgehend rechnergestützten und somit automatisch optimierten Bildqualität ohne zeitaufwendiges Auswechseln oder manuelles Positionieren der HF-Spulenanordnung. Dies bedeutet insbesondere bei einem Axialsystem eine erhebliche Zeitersparnis, da der Patient nicht mehr aus dem betreffenden MR-Bildgerät herausgefahren werden muss.

Eine Änderung der wirksamen Position der Spulenanordnung sowie deren Größe, die die Eindringtiefe des Feldes in das Gewebe bestimmt, ist durch eine entsprechende Auswahl der HF-Spule(n) möglich. Der Verlauf des Feldes der Spulenanordnung, das heißt insbesondere dessen Homogenität und Symmetrie, kann durch Veränderung der Amplitude, der Phase und / oder der Form des HF-Sendepulses optimiert werden.

Die Unteransprüche haben vorteilhafte Weiterbildungen der Erfindung zum Inhalt.

Mit der Ausführung gemäß Anspruch 2 werden diese Vorteile auch bei einem Betrieb der HF-Spulenanordnung zum Empfangen von HF-Signalen erzielt.

Der Verlauf des Sende- bzw. Empfangsfeldes ist mit der Ausführung gemäß Anspruch 3 optimierbar.

Die Ausführungen gemäß den Ansprüchen 4 bis 6 sind im Hinblick auf die oben genannten Parameter besonders flexibel einstellbar.

Die Ausführung gemäß Anspruch 7 betrifft insbesondere MR-Bildgeräte mit einem rohrförmigen Untersuchungsraum (Axialsysteme), während die Ausführung gemäß Anspruch 8 als Körperspule unabhängig von der Art des MR-Bildgerätes eingesetzt werden kann.

Weitere Einzelheiten, Merkmale und Vorteile der Erfindung ergeben sich aus der folgenden Beschreibung von bevorzugten Ausführungsformen anhand der Zeichnung. Es zeigt:
- Fig. 1: einen schematischen Längsschnitt durch ein MR-Bildgerät;
- Fig. 2: ein Prinzipschaltbild der wesentlichen Komponenten eines MR-Bildgerätes;
- Fig. 3: ein Blockschaltbild einer Ansteuerschaltung für die Spulen;
- Fig. 4: eine schematische Darstellung einer ersten Spulenanordnung;
- Fig. 5: eine schematische Darstellung einer ersten Kombination von Spulenanordnungen;
- Fig. 6a, 6b: schematische Darstellungen einer zweiten und einer dritten Kombination von Spulenanordnungen;
- Fig. 7: eine schematische Darstellung einer zweiten Spulenanordnung;
- Fig. 8: eine erste schematische Darstellung des Feldverlaufes einzelner Spulen;
- Fig. 9: eine zweite schematische Darstellung des Feldverlaufes einzelner Spulen;
- Fig. 10: ein Blockschaltbild einer Einrichtung zur Ansteuerung der Spulenanordnungen;
- Fig. 11: eine schematische Darstellung einer dritten Spulenanordnung;
- Fig. 12: eine schematische Darstellung einer vierten Spulenanordnung;
- Fig. 13: eine schematische Darstellung einer fünften Spulenanordnung;
- Fig. 14: eine schematische Darstellung einer sechsten Spulenanordnung;
- Fig. 15: eine schematische Darstellung einer vierten Kombination von Spulenanordnungen;
und
- Fig. 16: die vierte Kombination von Spulenanordnungen im Querschnitt.

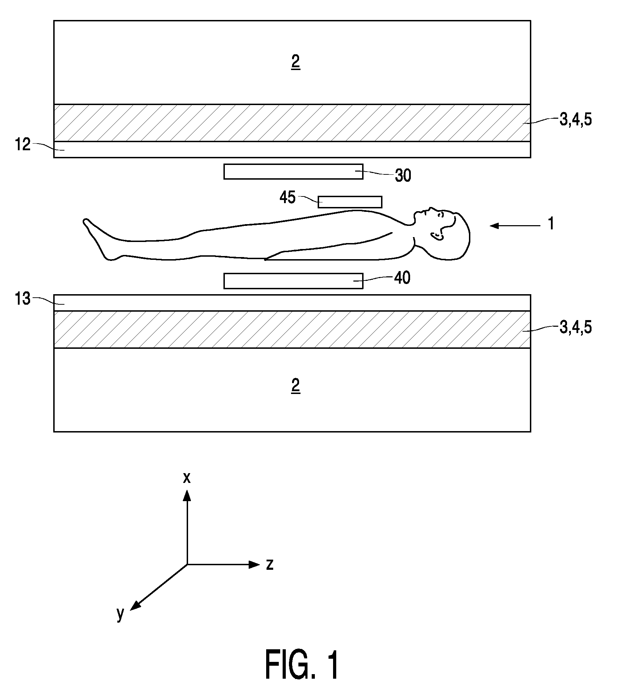

Figur 1 zeigt schematisch einen Längsschnitt durch ein Magnetresonanz-Bildgerät (Kernspinuntersuchungsgerät) mit einem rohrförmigen Untersuchungsraum (Axialsystem). In dem Untersuchungsraum befindet sich ein Untersuchungsobjekt 1, zum Beispiel ein Patient. Der Untersuchungsraum ist von einer Magnetspule 2 zur Erzeugung eines diesen in Axialrichtung (z-Richtung) durchsetzenden, homogenen, stationären Grundmagnetfeldes (B₀-Feld, Hauptfeld zur Magnetisierung des Untersuchungsobjektes, d. h. zur Ausrichtung der Kernspins) umgeben, wobei die magnetische Flussdichte (magnetische Induktion) in der Größenordnung von einigen Zehntel Tesla bis einigen Tesla liegen kann.

Zur räumlichen Unterscheidung und Auflösung der von dem Untersuchungsobjekt 1 ausgehenden Signale umgeben den Untersuchungsraum drei Gradient-Magnetfeldspulen 3, 4, 5 (nicht im einzelnen dargestellt), mit denen drei in Richtung der z-Achse verlaufende Gradient-Magnetfelder erzeugt werden. Ein erstes Gradient-Magnetfeld ändert sich dabei im wesentlichen linear in Richtung der x-Achse, ein zweites Gradient-Magnetfeld ändert sich im wesentlichen linear in Richtung der y-Achse, und ein drittes Gradient-Magnetfeld ändert sich im wesentlichen linear in Richtung der z-Achse.

Zur Anregung einer Kernmagnetisierung (Kernspinresonanz) in dem Untersuchungsobjekt befindet sich über dem Objekt eine durch einen HF-Impuls beaufschlagbare HF-Sendespulenanordnung 30 (HF-Flächenresonator), durch die das Objekt mit einem HF-Magnetfeld (B₁-Feld) durchsetzt werden kann. Zur Erfassung der sich an die Anregung anschließenden Relaxation, die eine erneute Änderung der Magnetisierungszustände in dem Objekt bewirkt, dient eine unter dem Objekt angeordnete HF-Empfangsspulenanordnung 40 (HF-Flächenresonator), in der durch diese Änderung eine korrespondierende Spannung induziert wird. Bei entsprechendem Umschalten kann zum Senden und Empfangen auch eine gemeinsame HF-Spulenanordnung verwendet werden, oder es dienen beide HF-Spulenanordnungen zum abwechselnden gemeinsamen Senden und Empfangen. Zwischen den HF-Spulenanordnungen 30; 40 und den jeweils benachbarten Gradient-Magnetfeldspulen 3, 4, 5 ist jeweils eine HF-Abschirmung 12, 13 zur jeweiligen Abschirmung der HF-Spulenanordnungen gegenüber den Gradient-Magnetspulen angeordnet.

Weiterhin können für bestimmte Untersuchungen auch HF-Körperspulenanordnungen 45 als Empfangsspulen verwendet werden, die direkt an den Patienten 1 beziehungsweise den zu untersuchenden Bereich angelegt werden. Diese HF-Körperspulen sind im allgemeinen flexibel und in Form von Pads oder Manschetten ausgebildet.

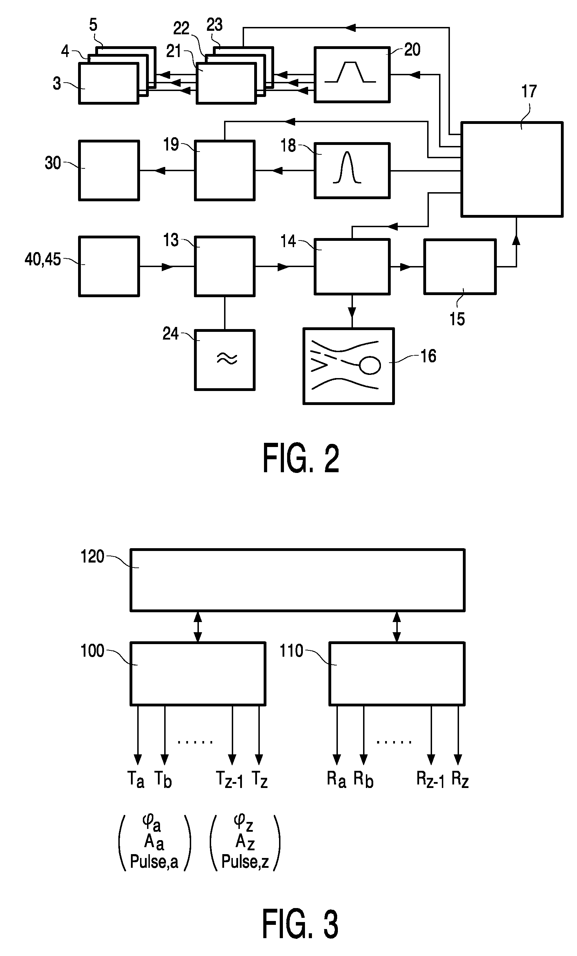

Die von den HF-Spulenanordnungen 40, 45 empfangenen Signale werden zur MR-Bilderzeugung ausgewertet, wobei die Gradient-Magnetfelder eine Lokalisierung der angeregten Zustände ermöglichen.
Die zum Betrieb dieser MR-Bildgeräte wesentlichen Komponenten sind schematisch in Figur 2 dargestellt und umfassen eine Steuereinheit 17, die einen Gradienten-Wellenform-Generator 20 ansteuert, an dessen Ausgängen jeweils ein erster, ein zweiter und ein dritter Gradientenverstärker 21, 22, 23 angeschlossen ist. Diese Verstärker erzeugen jeweils den Strom für die Gradientspulen 3, 4, 5. Die Verstärkungsfaktoren dieser Verstärker sind unabhängig voneinander einstellbar, wobei die Spulen die Gradientfelder in den x-, y- und z-Richtungen erzeugen und in an sich bekannter Weise eine Schichtselektion in den entsprechenden drei Raumrichtungen in dem untersuchten Bereich vorgenommen werden kann.

Weiterhin ist für jede Sendespule einer HF-Spulenanordnung ein Sendekanal vorgesehen, der durch die Steuereinheit 17 gesteuert wird und im wesentlichen jeweils einen HF-Generator 18 umfasst, mit dem die Frequenz der HF-Impule auf die von den Gradientfeldern abhängigen Larmor-Frequenzen abgestimmt wird. Die HF-Impulse werden einem durch die Steuereinheit 17 gesteuerten Verstärker 19 zugeführt, mit dem deren Amplitude, Phase und Impulsform eingestellt wird, und gelangen anschließend zu der sendenden HF-Spulenanordnung 30.

Die in den zum Empfang vorgesehenen HF-Spulenanordnungen 40, 45 durch die Relaxation der angeregten Magnetisierungszustände induzierten MR-Signale werden in einem jeder Spule zugeordneten Empfangskanal mit einem Quadratur-Demodulator 13 durch Mischung mit zwei um 90° gegeneinander versetzten Trägerschwingungen (mit einer durch die lokale Stärke der stationären Magnetfelder bestimmten Larmor- bzw. MR-Frequenz) eines Oszillators 24 demoduliert, so dass zwei Signale entstehen, die als Realteil und als Imaginärteil eines komplexen Signals aufgefasst werden können. Diese Signale werden einem Analog-Digitalwandler 14 zugeführt. Mit einer Bildverarbeitungseinheit 15 werden schließlich die MR-Bilder in bekannter Weise rekonstruiert und auf einem Monitor 16 wiedergegeben.

Die erfindungsgemäßen HF-Spulenanordnungen können sowohl in dem oben beschriebenen Axialsystem, als auch in einem Vertikalsystem (offenes MR-Bildgerät) mit einem den Untersuchungsraum vertikal durchsetzenden Grundmagnetfeld angewendet werden. Weiterhin können die erfindungsgemäßen HF-Spulenanordnungen sowohl als Sendespulen 30, als auch als Empfangsspulen 40, 45 eingesetzt werden, wobei für einen alternierenden Betrieb jede Spule mit einem kombinierten und zum Beispiel mit Dioden entsprechend umschaltbaren Sende-/Empfangskanal S/R verbunden ist.

Figur 3 zeigt ein Blockschaltbild einer Vorrichtung, mit der die Sende-/Empfangskanäle S/R jeder einzelnen Spule einer HF-Spulenanordnung angesteuert werden. Die Vorrichtung umfasst für jede HF-Spule eine Sendeeinheit und eine Empfangseinheit, die in Figur 3 zu einer Sendeeinrichtung 100 mit z Kanälen beziehungsweise einer Empfangseinrichtung 110 mit jeweils z Kanälen (z = Anzahl der HF-Spulen) zusammengefasst sind. An den Ausgängen der Sendeeinrichtung 100 liegen HF-Spannungen T mit getrennt einstellbarer Phase, Amplitude und Pulsform für die HF-Spulen an. An den Eingängen der Empfangseinrichtung 110 liegen die HF-Empfangssignale R jeder HF-Spule an. Mit beiden Einrichtungen 100, 110 ist schließlich ein MR-Spektrometer 120 bidirektional verbunden, über den die Sendeeinrichtung 100 eingestellt und die empfangenen Signale ausgewertet werden.

Wenn die im folgenden beschriebenen HF-Spulenanordnungen als Körperspulen verwendet werden sollen, sind diese auf ein entsprechend flexibles Trägermaterial aufgebracht und zur Korrektur von durch eine Biegung verursachten Veränderungen der elektrischen Eigenschaften ggf. mit Vorverstärkern mit entsprechenden Netzwerken verbunden.

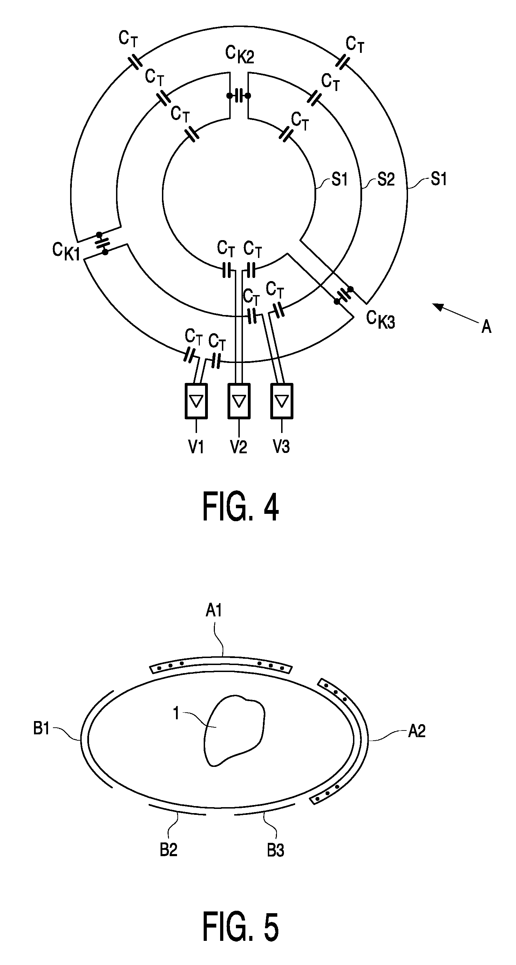

Figur 4 zeigt eine erste Ausführungsform einer erfindungsgemäßen HF-Spulenanordnung, die aus drei konzentrisch ineinander angeordneten einzelnen Oberflächenspulen S1, S2, S3 (allgemein mit Sx bezeichnet) zusammengesetzt ist. Die Spulen sind magnetisch voneinander entkoppelt. Dazu dienen drei Entkopplungskondensatoren C_{K1}, C_{K2}, C_{K3} zwischen den einzelnen Spulen, mit denen die Strom-Phasenverteilung in der Spulenanordnung beeinflusst wird und die so abgestimmt sind, dass eine Gegenkopplung der verschiedenen Moden erzielt wird.

Zur Entkopplung können zusätzlich oder alternativ auch kleine Transformatoren, zum Beispiel solche in Ringkernausführung (geringes Streufeld) eingesetzt werden, bei denen zwei Induktivitäten auf einen gemeinsamen Kern gewickelt sind. Dies gilt für alle im folgenden beschriebenen Ausführungsformen.

Jede Spule ist mit einem eigenen Vorverstärker V1, V2, V3 (allgemein mit Vx bezeichnet) sowie zugehörigem Empfangskanal und / oder Sendekanal verbunden, so dass gleichzeitig drei verschiedene Bilder erzeugt bzw. aufgenommen werden können. Weiterhin sind eine Anzahl von Abstimm-Kondensatoren C_{T} in verschiedene Leitungsabschnitte der einzelnen HF-Spulen eingeschaltet. Dadurch können in Leitungsschleifen (Maschen) aus diesen Leitungsabschnitten Resonanzen und somit Stromveränderungen in der oder den betreffenden HF-Spulen hervorgerufen werden.

Eine solche HF-Spulenanordnung kann durch Auswahl einer oder mehrerer der einzelnen Spulen S1, S2, S3 elektrisch an den zu untersuchenden Bereich angepasst werden, so dass in Abhängigkeit von dessen Art, Größe, Tiefe, Bewegung usw. ein optimales Bild im Hinblick auf das Signal/Rausch-Verhältnis, das Auflösungsvermögen und / oder im Hinblick auf eine minimale Bewegungsunschärfe erzeugt werden kann.

Zum Beispiel ist die Eindringtiefe des Sende- bzw. Empfangsfeldes einer HF-Spule im wesentlichen proportional zu deren Größe. Bei kreisförmigen Spulen, wie sie in Figur 4 dargestellt sind, ist die wirksame Eindringtiefe im wesentlichen gleich ihrem Radius. Wenn somit das abzubildende Gewebe an der Körperoberfläche liegt, sollte die Spule S2 oder S3 zum Senden und Empfangen gewählt werden.

Durch die Kombination der Bilder von zwei Spulen kann lokal das Signal/Rausch-Verhältnis verbessert werden. Wenn also im Fall der Figur 4 beispielsweise die erste und die dritte Spule S1, S3 gleichzeitig verwendet werden, setzt sich die gesamte integrale Rauschspannung in dem kombinierten Bild aus den Beiträgen von zwei verschiedenen Volumina zusammen. Die Korrelation des Rauschens ist abhängig von der Gesamtgröße, der Form, der Leitfähigkeit und der Position des abgebildeten Bereiches relativ zu den Spulen. Somit können die von den beiden Spulen erzeugten Rauschanteile nicht vollständig miteinander korreliert sein. Vielmehr ergibt sich in dem dargestellten Fall eine Korrelation von weniger als 30 Prozent. Dadurch wird in dem von beiden Spulen S1, S3 erfassten Bereich, nämlich dem Bereich, der nahe unter der Körperoberfläche liegt, ein höheres Signal/Rausch-Verhältnis erzielt, als in dem nur von der größeren ersten Spule S1 erfassten tieferen Bereich.

Die HF-Spulenanordnung kann schließlich auch in Kombination mit anderen einzelnen Körperspulen angewendet werden, die zusammen in geeigneter Weise an gegenüberliegenden Seiten eines zu untersuchenden Bereiches bzw. des Körpers des Patienten 1 angeordnet werden, um auch von bewegten Bereichen (z. B. Herz) ein optimales Bild erzeugen zu können. Hierfür werden möglichst kurze Aufnahmezeiten angestrebt, um ein gutes zeitliches Auflösungsvermögen zu erzielen. Insbesondere unter Anwendung der bekannten SENSE (sensitivity encoding)-Bildgebung können bei einer ausreichenden Feldabdeckung (field of view) kurze Aufnahmezeiten gewählt und eine entsprechend größere Anzahl von Aufnahmen gemacht werden. Ein hierbei etwas schlechteres Signal/Rausch-Verhältnis kann durch eine Volumenspule, die sich aus mehreren einzelnen Spulen oder Spulenanordnungen zusammensetzt, vermieden werden.

Figur 5 zeigt ein Beispiel einer solchen ersten Kombination von Spulenanordnungen für eine koronare Untersuchung, bei der um den Oberkörper eines Patienten 1 zwei anpassbare HF-Spulenanordnungen A1, A2 und drei einzelne Oberflächen-Spulen B1, B2, B3 angeordnet sind. Auf diese Weise wird eine optimal angepasste Volumen-Spulenanordnung realisiert. Eine Entkopplung der verschiedenen Spulen A1, A2, B1, B2, B3 untereinander kann durch eine teilweise Überlappung oder einen ausreichenden Abstand voneinander und / oder eine Anpassung über L/C-Schaltungen erzielt werden.

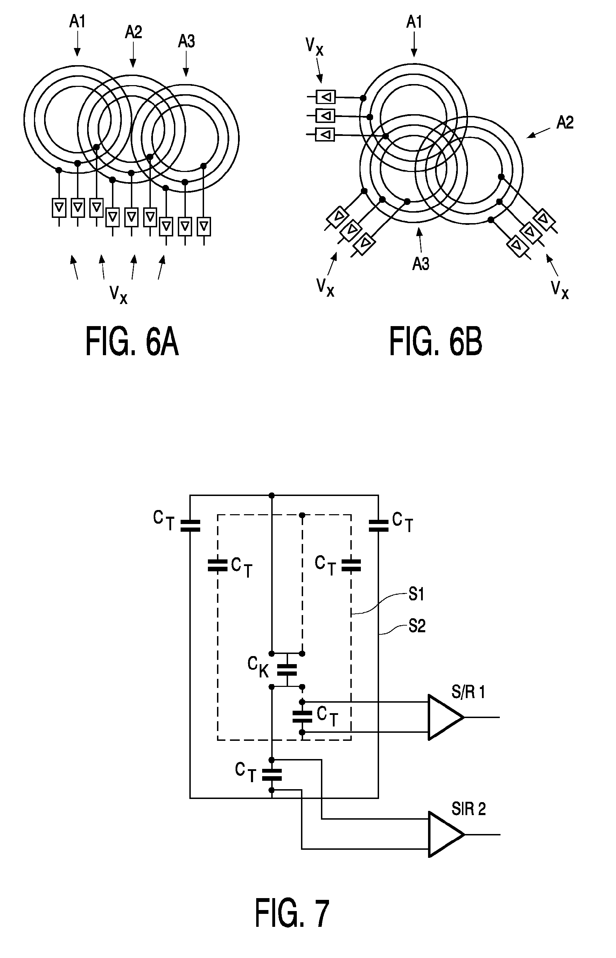

Neben der oben beschriebenen Einstellbarkeit der wirksamen Größe der HF-Spulenanordnung ist es für bestimmte Untersuchungen wichtig, auf möglichst einfache Weise auch deren wirksame Position relativ zu einem Patienten verändern zu können. Zu diesem Zweck können mehrere der oben beschriebenen HF-Spulenanordnungen A1, A2, A3 überlappend in verschiedener Weise nebeneinander an dem zu untersuchenden Bereich angeordnet werden. Figur 6a zeigt eine solche zweite Kombination, während in Figur 6b eine dritte Kombination von HF-Spulenanordnungen dargestellt ist.

Die gegenseitige magnetische Entkopplung wird dabei entweder durch die Überlappung oder einen ausreichenden Abstand der HF-Spulenanordnungen voneinander erzielt. Über entsprechende Umschalter kann der Benutzer des Systems die HF-Spulenanordnung A1, A2, A3 mit der optimalen Position auswählen. Die einzelnen Spulen S1, S2, S3 jeder Spulenanordnung werden wiederum über jeweilige Sende-/Empfangskanäle V1, V2, V3 (allgemein mit Vx bezeichnet) betrieben.

Zusätzlich oder alternativ können in diesen und anderen Kombinationen auch eine oder mehrere "Butterfly"-Spulenanordnungen verwendet werden, von denen eine beispielhafte Ausführung in Figur 7 gezeigt ist. Diese Spulenanordnung setzt sich aus zwei ineinander verschachtelten einzelnen Butterfly-Spulen S1, S2 zusammen, die über eine Kapazität C_{K} voneinander entkoppelt sind. Zur Abstimmung ist wiederum eine Anzahl von Abstimm-Kondensatoren C_{T} in verschiedenen Leitungsabschnitten der einzelnen HF-Spulen vorgesehen. Jede Spule ist auch hier mit einem kombinierten Sende-/Empfangskanal S/R1 bzw. S/R2 verbunden.

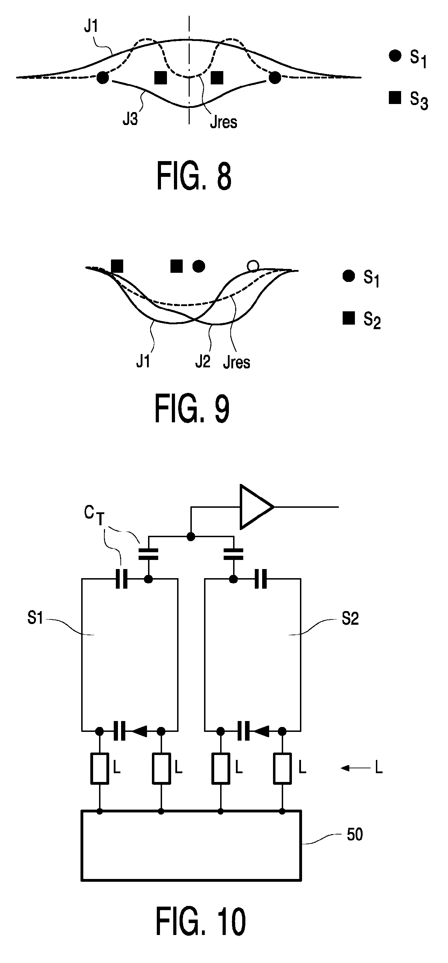

Ein weiteres Problem kann schließlich darin bestehen, dass der Feldstärkeverlauf einer einzelnen HF-Spule auf Grund von dielektrischen Resonanzeffekten verzerrt bzw. inhomogen ist. Die Näherung des Bio-Savart-Gesetzes für niedrige Frequenzen führt dabei zu starken Abweichungen im Vergleich zu den tatsächlich gemessenen Werten. Mit der oben beschriebenen HF-Spulenanordnung kann eine Korrektur und Abstimmung dieser dielektrischen Resonanzeffekte vorgenommen werden, indem gemäß Figur 8 die Phasen- bzw. Amplitudenverläufe der Ströme I1, I3 auf zwei einzelnen, ineinander liegenden Spulen S1, S3 in geeigneter Weise verändert und kombiniert werden, so dass sich ein ausgeglichenerer, d.h. homogener Verlauf Ires ergibt. Zu diesem Zweck können zum Beispiel die Entkopplungskondensatoren C_{K} durch Einsatz von Kapazitätsdioden oder geschalteten Kondensatoren umschaltbar ausgelegt werden, so dass der Benutzer des Systems den Feldstärkeverlauf aktiv verändern kann. Mit einer solchen aktiven Steuerung der Homogenität des Feldstärkeverlaufes kann die Bildqualität insbesondere bei hohen Feldstärken weiter verbessert werden.
Insbesondere bei relativ hohen HF-Frequenzen und hohen Feldstärken (z. B. 128 MHz, 3 Tesla) wird die links-rechts-Symmetrie der Feldhomogenität einer HF-Spule durch die bekannten LISA (local intensity shift artefacts)- und dielektrische Resonanz-Effekte gestört. Diese Effekte und ihre Ursachen sind in "Magnetic Resonance in Medicine" 1989, Seite 1175 erläutert. Zur Beseitigung dieser Störungen wird gemäß Figur 9 eine Konfiguration gewählt, bei der eine Spule in zwei einzelne, voneinander entkoppelte Spulen aufgeteilt ist oder zwei einzelne Spulen S1, S2 verwendet werden, die eine HF-Spulenanordnung aus zwei nebeneinander liegenden einzelnen Spulen bilden. Zur aktiven Steuerung der links-rechts-Symmetrie der Homogenität des Feldes sowie allgemein zur Erzielung eines gewünschten Feldverlaufes ist gemäß Figur 10 eine Einrichtung 50 zur Abstimm-Steuerung vorgesehen, mit der die Kopplung zwischen den einzelnen Spulen S1, S2 verändert werden kann. Insbesondere können die Spulen in bestimmtem Maße mittels Induktivitäten L induktiv miteinander gekoppelt werden, und der HF-Strom durch die Spulen kann mittels Abstimm-Kondensatoren C_{T} gesteuert werden, so dass eine zumindest weitgehende links-rechts-Symmetrie erzielt wird.

Die beschriebene Homogenitätssteuerung des Feldes von HF-Spulen ist insbesondere bei der genannten SENSE (sensitivity encoding)-Bildgebung vorteilhaft anwendbar. Dieses Verfahren ist in "Proceedings of the International Society of Magnetic Resonance in Medicine" 2000, Seite 152 und in "Magnetic Resonance in Medicine" 1999, Seite 952 ff erläutert. Der dort beschriebene Geometriefaktor g kann durch Einstellung der Homogenität des Feldes der HF-Spulenanordnung durch entsprechende Ansteuerung der Spulen optimiert werden, wobei im Falle mehrerer Spulenanordnungen zum Beispiel gemäß Figur 5 eine der anpassbaren HF-Spulenanordnungen A1, A2 entsprechend eingestellt wird.

Eine weitere Anwendbarkeit ergibt sich in dem Fall, in dem die oben beschriebenen HF-Spulenanordnungen zum Senden verwendet werden. Bei der in Figur 4 gezeigten HF-Spulenanordnung ist eine gegenseitige magnetische Entkopplung der drei ineinander liegenden einzelnen HF-Oberflächenspulen S1, S2, S3 von etwa -20 dB wünschenswert. Das lokale Gesamt-Sendefeld dieser Anordnung kann durch entsprechende Einstellung der Phasen bzw. Amplituden der Ströme auf den einzelnen Spulen entweder aktiv homogenisiert oder für die oben genannte SENSE-Bildgebung geformt werden. In diesem Fall ist eine räumliche Codier- oder Umcodier-Funktionalität sinnvoll, bei der gleichzeitig Pulse auch mit unterschiedlichen Formen gesendet werden können, um eine Bildgebung mit verbesserter zeitlicher und räumlicher Auflösung zu erzielen. Es können auch hier wiederum mehrere anpassbare HF-Spulenanordnungen A1, A2,.. zusammengefasst werden.

Diese Verfahren werden insbesondere bei der Herz- und Kopf-Bildgebung angewendet, wobei im letzteren Fall eine Spulenanordnung verwendet wird, die eine Spule mit einem relativ großen Durchmesser sowie eine Mehrzahl von Spulen mit relativ kleinem Durchmesser aufweist, die entlang des Umfangs der großen Spule angeordnet sind.

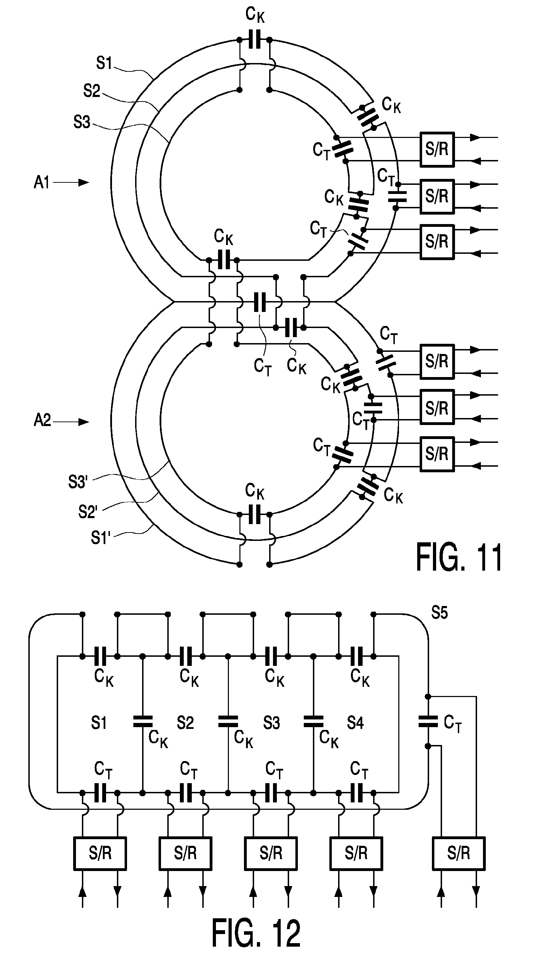

Eine dritte HF-Spulenanordnung ist in Figur 11 gezeigt. Hierbei sind zwei einzelne HF-Spulenanordnungen A1, A2 der in Figur 4 gezeigten Art nebeneinander eingeordnet, wobei die äußeren Spulen S1 der beiden Spulenanordnungen einen gemeinsamen Abschnitt aufweisen. Die Entkopplung der einzelnen Spulen wird wiederum mit den Entkopplungskondensatoren C_{K} erzielt. Eine Anzahl von Abstimm-Kondensatoren C_{T} ist in verschiedene Leitungsabschnitte der einzelnen HF-Spulen eingeschaltet. Mit jeder der insgesamt sechs Einzelspulen S1, S2, S3, S1', S2', S3' ist jeweils ein kombinierter Sende/Empfangskanal S/R verbunden, über den jede Einzelspule im Sendefall mit HF-Strömen verschiedener Amplitude und Phase und ggf. verschiedener Pulsform beaufschlagt werden kann, um gemäß obiger Beschreibung eine gewünschte Symmetrie, Homogenität oder Abstrahlungscharakteristik bzw. eine wirksame Größe und wirksame Position der Gesamtanordnung zu erzielen.

Dies kann gemäß obiger Beschreibung auch durch entsprechende Auswahl und Kombination der einzelnen Spulen bzw. Spulenanordnungen erreicht werden.

Figur 12 zeigt eine vierte HF-Spulenanordnung, bei der vier nebeneinanderliegende HF-Spulen S1, S2, S3, S4 von einer fünften HF-Spule S5 umgeben sind. Die Spulen sind wiederum mit Entkopplungskondensatoren C_{K} voneinander entkoppelt, und eine Anzahl von Abstimm-Kondensatoren C_{T} ist in verschiedene Leitungsabschnitte der einzelnen HF-Spulen eingeschaltet. Auch hierbei ist jede einzelne Spule mit einem gesondert ansteuerbaren Sende-/Empfangskanal S/R verbunden. Mit dieser HF-Spulenanordnung können mit der ersten bis vierten Spule S1 bis S4 Felder mit relativ geringer Eindringtiefe erzeugt werden, die von einem mit der fünften Spule S5 erzeugten Feld mit größerer Eindringtiefe überlagert sind. Durch wahlweise Kombination dieser Spulen gemäß obiger Erläuterung kann somit an einer gewünschten Stelle eines Untersuchungsbereiches ein optimales Signal/Rausch-Verhältnis erzielt werden.

Die dritte und vierte HF-Spulenanordnung ist insbesondere zur Anwendung mit einem SENSE-Bildgebungsverfahren geeignet.

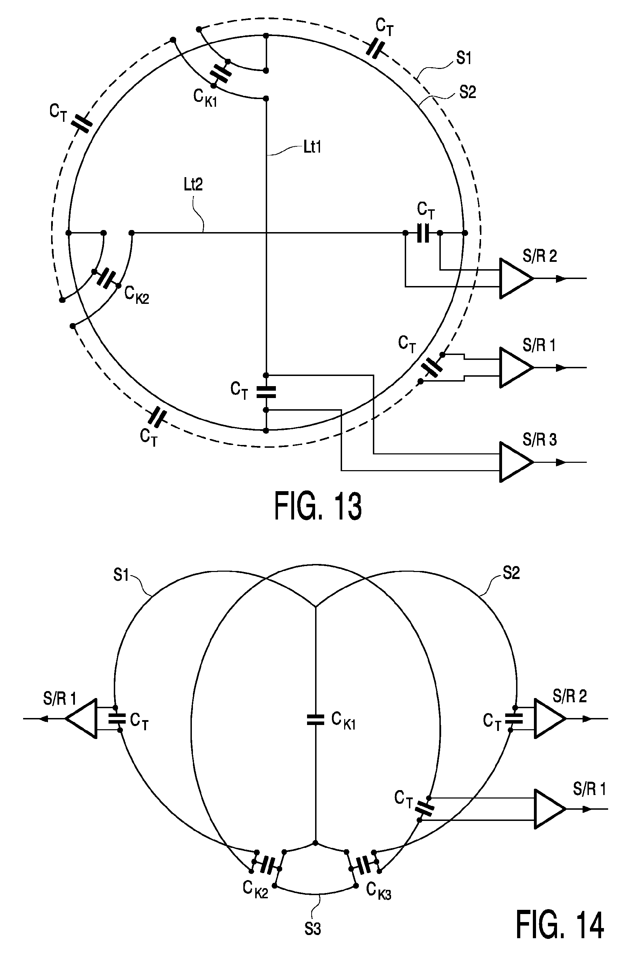

Eine fünfte HF-Spulenanordnung ist in Figur 13 gezeigt, bei der eine erste äußere Spule S 1 eine zweite innere Spule S2 umschließt. Die erste Spule S 1 wird über einen ersten Sende-/Empfangskanal S/R1 betrieben. In die zweite Spule S2 sind zwei Leiter Lt1, Lt2 geschaltet, die senkrecht zueinander verlaufen und mit einem Winkelabstand von 90 Grad mit der zweiten Spule S2 verbunden sind. Mit jedem der Leiter ist jeweils ein Sende/Empfangskanal S/R2, S/R3 zum Betreiben der zweiten Spule S2 verbunden. Die beiden Spulen S1, S2 sind mittels Entkopplungskondensatoren C_{K1}, C_{K2} voneinander entkoppelt, wobei wiederum Abstimm-Kondensatoren C_{T} in verschiedene Leitungsabschnitte der einzelnen HF-Spulen eingeschaltet sind.

Diese fünfte HF-Spulenanordnung ist insbesondere in einem HFO (High field open)-System (offenes MR-System) vorteilhaft anwendbar. Die Spulenanordnung kann unabhängig von der Feld-Orientierung eingesetzt werden, da durch Auswahl eines der drei Sende-/Empfangskanäle S/R1, S/R2, S/R3 stets die dementsprechend geeignete HF-Spule aktiviert werden kann.

Figur 14 zeigt eine sechste HF-Spulenanordnung, bei der eine erste und eine zweite Spule S1, S2, die nebeneinander liegen und über einen gemeinsamen Zweig mit einer ersten Kapazität C_{K1} voneinander entkoppelt sind, von einer dritten Spule S3 überlagert sind. Die dritte Spule ist mit einer zweiten Kapazität C_{K2} von der ersten Spule S 1 und mit einer dritten Kapazität C_{K3} von der zweiten Spule S2 entkoppelt. Jede der drei Spulen weist wiederum Abstimm-Kondensatoren C_{T} auf und wird über jeweils einen Sende-/Empfangskanal S/R1, S/R2, S/R3 betrieben.

Ein besonderer Vorteil dieser sechsten HF-Spulenanordnung ist darin zu sehen, dass durch einfaches Umschalten bzw. Auswählen der Spulen S1, S2 und / oder S3 eine Anpassung an unterschiedliche Größen der Patienten möglich ist.

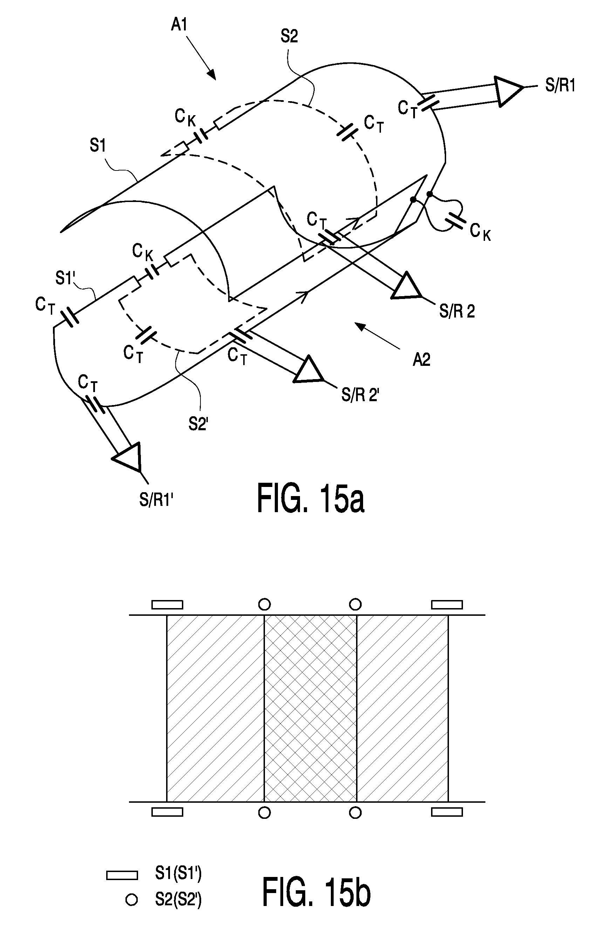

Für ein MR-Bildgerät mit einem rohrförmigen Untersuchungsraum gemäß Figur 1 bietet sich eine (vierte) Kombination von HF-Spulenanordnungen aus sogenannten Sattelspulen an, wie sie zum Beispiel in Figur 15a in dreidimensionaler Darstellung und in Figur 15b in Draufsicht schematisch gezeigt sind.

Die HF-Sattelspulenanordnungen A1, A2 erstrecken sich entlang des Untersuchungsraums und liegen einander gegenüber. Sie setzen sich jeweils aus einer ersten längeren Spule S1, S1' sowie einer dieser überlagerten zweiten kürzeren Spule S2, S2' zusammen. Die einzelnen Spulen S1, S2; S1', S2' sind wiederum mit Abstimm-Kondensatoren C_{T} verschaltet und mit Entkopplungskondensatoren C_{K} voneinander entkoppelt und werden jeweils über eigene Sende-/Empfangskanäle S/R1, S/R2; S/R1', S/R2' betrieben. In Figur 15b sind die Felder der einzelnen Spulen durch unterschiedliche Schraffierung angedeutet. Aus dieser Darstellung wird deutlich, dass sich im Bereich der kürzeren Spule S2 (S2') die Felder beider Spule addieren, so dass in diesem Bereich ein verbessertes Signal/Rausch-Verhältnis der HF-Spulenanordnung gemäß obiger Erläuterung im Zusammenhang mit Figur 4 erzielt werden kann.

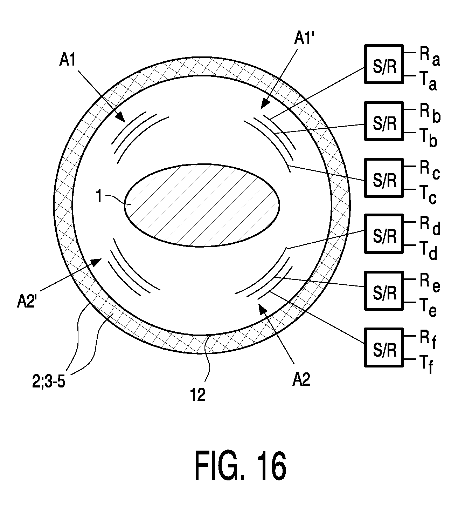

Figur 16 zeigt schematisch einen Querschnitt durch einen rohrförmigen Untersuchungsraum mit den in Figur 15a gezeigten Spulen. Am Umfang dieses Raumes sind die zur Erzeugung des Hauptmagnetfeldes und der Gradient-Magnetfelder erforderlichen Spulen 2; 3-5 angeordnet, die vom Innenraum durch eine HF-Abschirmung 12 getrennt sind. In dem Innenraum ist schematisch ein Patient 1 angedeutet, der von zwei Paaren aus jeweils zwei einander gegenüberliegenden HF-Spulenanordnungen A1, A2; A3, A4 mit jeweils drei einzelnen HF-Spulen umgeben ist. Die HF-Spulenanordnungen sind dabei in Umfangsrichtung um etwa 90 Grad zueinander versetzt. Jede einzelne HF-Spule wird über einen eigenen Sende-/Empfangskanal S/R betrieben, an dem die Sendesignale T und die Empfangssignale R anliegen.

Eine oder mehrere der erfindungsgemäßen HF-Spulenanordnungen werden vorzugsweise in einem Magnetresonanz-Bildgerät verwendet, mit dem die HF-Spulen bzw. Spulenanordnungen zum Beispiel in Abhängigkeit von der Art, Größe, Lage usw. des abzubildenden Untersuchungsobjektes rechnergesteuert und somit weitgehend automatisch ausgewählt und angesteuert werden können.

## Patentansprüche

1. HF-Spulenanordnung, insbesondere zur Anwendung in einem Magnetresonanz-Bildgerät, mit einer Mehrzahl von einzelnen, im wesentlichen voneinander entkoppelten HF-Spulen (Sx) mit unterschiedlicher Größe und / oder unterschiedlicher Position, sowie mit einer Mehrzahl von Sendeeinheiten (100), die jeweils einer HF-Spule (Sx) zugeordnet sind, zur Auswahl einer oder mehrerer HF-Spulen und zur Beaufschlagung der ausgewählten HF-Spulen mit einem HF-Sendepuls mit unabhängig einstellbarer Amplitude und / oder Phase und / oder Pulsform.

2. HF-Spulenanordnung nach Anspruch 1,
mit einer Mehrzahl von Empfangseinheiten (110), die jeweils einer HF-Spule (Sx) zugeordnet und einzeln aktivierbar oder deaktivierbar sind.

3. HF-Spulenanordnung nach Anspruch 1,
bei der die Kopplung zwischen den HF-Spulen (Sx) mittels Kapazitäten (C_{K}) und / oder Induktivitäten (L) und / oder Transformatoren zur Erziehung eines gewünschten, insbesondere homogenen und symmetrischen Feldverlaufes der HF-Spulenanordnung einstellbar ist.

4. HF-Spulenanordnung nach Anspruch 1,
mit einer Mehrzahl von konzentrisch angeordneten HF-Spulen.

5. HF-Spulenanordnung nach Anspruch 1,
mit einer Mehrzahl von nebeneinander angeordneten HF-Spulen.

6. HF-Spulenanordnung nach Anspruch 1,
bei der eine Mehrzahl von ersten HF-Spulen (S 1 bis S4) nebeneinander angeordnet ist, die zusammen von einer zweiten HF-Spule (S5) umschlossen sind.

7. HF-Spulenanordnung nach Anspruch 1,
die durch mindestens eine erste, sich entlang der Oberfläche eines Zylinders erstreckende HF-Spule und eine zweite, dieser überlagerten, kürzeren HF-Spule gebildet ist.

8. HF-Spulenanordnung nach Anspruch 1,
die auf ein flexibles Trägermaterial aufgebracht ist, so dass sie als Körperspule anwendbar ist.

9. Magnetresonanz-Bildgerät mit mindestens einer HF-Spulenanordnung (Ax) nach einem der vorhergehenden Ansprüche.

10. Magnetresonanz-Bildgerät nach Anspruch 9 mit einer Rechnereinheit zur Auswahl der Sendeeinheiten (100) für die HF-Spulen (Sx) und zur Ansteuerung der ausgewählten Sendeeinheiten zur Beaufschlagung der ausgewählten HF-Spulen mit einem HF-Sendepuls mit unabhängig einstellbarer Amplitude und / oder Phase und / oder Pulsform.
